# EUROPÄISCHE PATENTSCHRIFT

(11) **EP 2 550 173 B1**
(45) Veröffentlichungstag und Bekanntmachung des Hinweises auf die Patenterteilung: **20.01.2016**
(21) Anmeldenummer: 11708721.3
(22) Anmeldetag: 08.03.2011
(51) Int. Cl.: G01R 19/155, G01R 31/00

(54) **VERFAHREN ZUM ÜBERPRÜFEN EINES ZUSTANDS EINES STROMKREISES EINES KRAFTFAHRZEUGS**
METHOD FOR EXAMINING A STATE OF A CIRCUIT OF A MOTOR VEHICLE
PROCÉDÉ POUR CONTRÔLER UN ÉTAT D'UN CIRCUIT ÉLECTRIQUE D'UN VÉHICULE AUTOMOBILE

(30) Priorität: 20.03.2010 DE 102010012154
(43) Veröffentlichungstag der Anmeldung: 30.01.2013
(73) Patentinhaber: Audi AG, 85045 Ingolstadt (DE)
(72) Erfinder: SICHERT, Werner, 85072 Eichstätt (DE)
(74) Vertreter: Herbst, Matthias Heinz
(86) Internationale Anmeldenummer: PCT/EP2011/001118
(87) Internationale Veröffentlichungsnummer: WO 2011/116880

(56) Entgegenhaltungen:
- DE-A1- 3 540 599
- DE-A1-102009 011 261
- US-A- 3 321 754

## Beschreibung

Die Erfindung betrifft ein Verfahren zum Überprüfen eines Zustands eines Stromkreises eines Kraftfahrzeugs.

Moderne Elektrofahrzeuge und Hybridfahrzeuge weisen typischerweise ein Hochspannungssystem auf. Sollen nun beispielsweise Wartungsarbeiten im Bereich dieses Hochspannungssystems an dem Fahrzeug vorgenommen werden, so müssen strenge Sicherheitsrichtlinien beachtet werden, um die Unfallgefahr zu vermindern.

Bisher wird deshalb in der Regel zunächst das Hochspannungssystem ausgeschaltet, indem der Stromkreis des Hochspannungssystems - beispielsweise durch Ziehen eines "Service Plugs" - unterbrochen wird. Dann muss festgestellt werden, ob tatsächlich an dem Hochspannungssystem keine Spannung mehr anliegt. Hierfür wird üblicherweise eine Mehrzahl von manuellen Messungen der in dem Stromkreis herrschenden Spannung durch einen Service-Techniker durchgeführt.

Um diese Spannung messen zu können, müssen zum Teil komplizierte Abbauten an dem Fahrzeug durchgeführt werden, damit der Service Techniker bestimmte Messstellen nutzen kann. Außerdem ist eine teure, spezielle Messausrüstung erforderlich. Da Stecker dieser Messausrüstung zum Messen der Spannung wiederholt an entsprechende Stecker des Hochspannungssystems des Fahrzeugs angesteckt und wieder abgesteckt werden, verschleißen die jeweiligen Stecker sehr schnell und müssen regelmäßig aufwendig ersetzt werden. Ein weiterer Nachteil herkömmlicher Verfahren ist, dass stets die Gefahr besteht, dass der Service-Techniker die Spannung an falschen Stellen des Hochspannungssystems des Fahrzeugs misst, so dass aus den Messwerten keine zuverlässige Aussage über den Zustand des Stromkreises ableitbar ist. Es kann also leicht zu gefährlichen Unfällen kommen.

Die US 3 321 754 A beschreibt ein System, mit dem eine Systemspannung in einem Kraftfahrzeug angezeigt werden kann. Das System umfasst einen Schaltkreis, mit dem beispielsweise die an einer Batterie anliegende Spannung überwacht werden kann. Wenn die Spannung einen vorgegebenen Grenzwert über- oder unterschreitet, wird ein entsprechendes Signal ausgegeben.

Es ist deshalb Aufgabe der vorliegenden Erfindung, ein Verfahren zum Überprüfen eines Zustands eines Stromkreises eines Kraftfahrzeugs bereitzustellen, welches einfach und kostensparend durchführbar ist und mittels welchem die Unfallgefahr reduziert werden kann.

Diese Aufgabe wird durch ein Verfahren zum Überprüfen eines Zustands eines Stromkreises eines Kraftfahrzeugs gemäß Patentanspruch 1 gelöst.

Erfindungsgemäß umfasst das Verfahren somit folgende Schritte:
- Anfordern eines Zustands für den Stromkreis,
- Messen eines aktuellen Werts für wenigstens eine auf den Stromkreis bezogene Größe, aus welcher der Zustand des Stromkreises ableitbar ist, durch zumindest eine Messeinheit des Kraftfahrzeugs,
- Prüfen durch zumindest eine Steuereinheit des Kraftfahrzeugs, ob der aktuelle Wert für die Größe zumindest einem für den angeforderten Zustand vorgegebenen Wert für die Größe entspricht,
- Anzeigen, dass der angeforderte Zustand des Stromkreises eingestellt ist, wenn der aktuelle Wert für die Größe dem zumindest einen für den angeforderten Zustand vorgegebenen Wert für die Größe entspricht.

Dadurch kann - beispielsweise nach dem Anfordern eines bestimmten Zustands für den Stromkreis durch eine Bedienperson - durch das Fahrzeug selbsttätig festgestellt werden, ob der angeforderte Zustand auch tatsächlich eingestellt wurde. Es muss nicht mehr in aufwändiger Weise manuell gemessen werden. Bereits im Fahrzeug vorhandene Messeinheiten können einfach genutzt und somit Kosten eingespart werden. Als vorgegebener Wert für die auf den Stromkreis bezogene Größe kann beispielsweise wenigstens ein Wert ausgewählt werden, welcher immer genau dann messbar ist, wenn der angeforderte Zustand des Stromkreises eingestellt ist.

Wird als auf den Stromkreis bezogene Größe des Stromkreises die Spannung des Stromkreises gemessen, so ist ganz einfach feststellbar, ob der für den Stromkreis angeforderte Zustand auch eingestellt wurde. Da in Elektrobeziehungsweise in Hybridfahrzeugen typischerweise bereits viele Spannungsmesseinheiten zum Messen der Spannung des dortigen Hochstromkreises vorhanden sind, können diese einfach genutzt werden.

Bevorzugt wird außerdem angezeigt, ob das Anfordern des Zustands für den Stromkreis erfolgte. Der Service Techniker kann dann anhand zweier unabhängiger Anzeigen den Fortgang des Verfahrens beobachten. Er weiß jederzeit, ob er bereits den Zustand für den Stromkreis angefordert hat und nur noch das autonome Überprüfen der Einstellung abwarten muss, oder ob er den Zustand für den Stromkreis noch anfordern muss.

Erfindungsgemäß wird parallel zu der Gesamtheit der Schritte des
- Messens des aktuellen Werts für die wenigstens eine auf den Stromkreis bezogene Größe, aus welcher der Zustand des Stromkreises ableitbar ist, durch die zumindest eine Messeinheit des Kraftfahrzeugs,
- Prüfens durch die zumindest eine Steuereinheit des Kraftfahrzeugs, ob der aktuelle Wert für die Größe zumindest einem für den angeforderten Zustand vorgegebenen Wert für die Größe entspricht, und des
- Anzeigens, dass der angeforderte Zustand des Stromkreises eingestellt ist, wenn der aktuelle Wert für die Größe dem zumindest einen für den angeforderten Zustand vorgegebenen Wert für die Größe entspricht,
eine zusätzliche gesamte Schrittfolge
- wenigstens eines weiteren Messens eines weiteren aktuellen Werts für die wenigstens eine auf den Stromkreis bezogene Größe durch die wenigstens eine Messeinheit des Kraftfahrzeugs, aus welcher der Zustand des Stromkreises ableitbar ist,
- zumindest eines weiteren Prüfens, ob der aktuelle Wert für die Größe zumindest einem vorgegebenen Wert für die Größe entspricht,
- und eines weiteren Anzeigens, dass der angeforderte Zustand des Stromkreises eingestellt ist, wenn der aktuelle Wert für die Größe dem zumindest einen für den angeforderten Zustand vorgegebenen Wert für die Größe entspricht,
von wenigstens einer weiteren Steuereinheit außerhalb des Kraftfahrzeugs veranlasst beziehungsweise durchgeführt.

Dadurch wird die Unfallgefahr - beispielsweise bei Wartungsarbeiten an dem Hochvoltsystem des Fahrzeugs - noch stärker reduziert. Es werden voneinander unabhängige Messungen der auf den Stromkreis bezogenen Größe von voneinander unabhängigen Steuergeräten veranlasst. Diese Prüfen anhand der Werte - ebenfalls unabhängig voneinander - ob der angeforderte Zustand für den Stromkreis tatsächlich eingestellt ist.

Ein vorliegend nicht beanspruchtes Kraftfahrzeug umfasst wenigstens einen Stromkreis
sowie wenigstens eine Messeinheit zum Messen einer auf den Stromkreis bezogenen Größe. Des Weiteren weist das Kraftfahrzeug Mittel zum Anfordern eines Zustands für den Stromkreis sowie zumindest eine Steuereinheit auf. Diese ist nun dazu ausgelegt,
- wenigstens einen aktuellen Wert für die Größe des Stromkreises von der Messeinheit zu empfangen,
- zu prüfen, ob der aktuelle Wert zumindest einem für den angeforderten Zustand vorgegebenen Wert für die Größe entspricht,
- und anzuzeigen, dass der angeforderte Zustand für den Stromkreis eingestellt ist, wenn der aktuelle Wert für die Größe des Stromkreises dem wenigstens einen vorgegebenen Wert für die Größe des Stromkreises entspricht.

Dadurch können die Kosten und der Zeitaufwand beispielsweise bei Wartungsarbeiten oder dergleichen an einem Hochspannungssystem des Fahrzeugs reduziert und die Unfallgefahr vermindert werden.

Bevorzugt umfasst das vorliegend nicht beanspruchte Kraftfahrzeug Mittel zum Austauschen von Daten mit einer Steuereinheit außerhalb des Kraftfahrzeugs. Durch diese kann dann unabhängig von der Steuereinheit des Kraftfahrzeugs
- das Messen wenigstens eines weiteren aktuellen Wertes für die auf den Stromkreis bezogene Größe von durch die Messeinheit des Kraftfahrzeugs veranlasst werden,
- geprüft werden, ob dieser weitere aktuelle Wert zumindest einem für den eingestellten Zustand vorgegebenen Wert für die Größe entspricht,
- angezeigt werden, dass der Zustand für den Stromkreis eingestellt ist, wenn der aktuelle Wert für die auf den Stromkreis bezogenen Größe dem wenigstens einen vorgegebenen Wert für die auf den Stromkreis bezogene Größe entspricht.

Hierdurch wird die Sicherheit für einen Service-Techniker bei Wartungsarbeiten weiter erhöht, da von unabhängigen Steuergeräten mehrere unabhängige Messungen veranlasst sowie Prüfungen durchgeführt werden.

Wenn die wenigstens eine Steuereinheit einen Speicher zum Speichern von Messwerten und/oder den vorgegebenen Werten umfasst, können Messprotokolle beziehungsweise die vorgegebenen Werte einfach in dem Speicher hinterlegt werden.

Nachfolgend wird eine bevorzugte Ausführungsform der vorliegenden Erfindung unter Bezug auf die Zeichnung beschrieben, wobei
- Fig. 1: schematisch die Schrittfolge des erfindungsgemäßen Verfahrens veranschaulicht und
- Fig. 2: schematisch ein Fahrzeug mit einem Stromkreis zeigt.

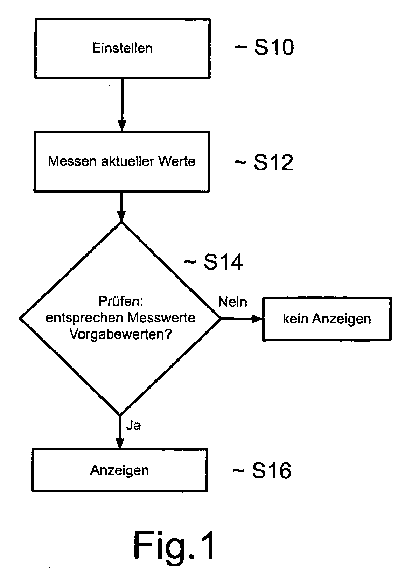

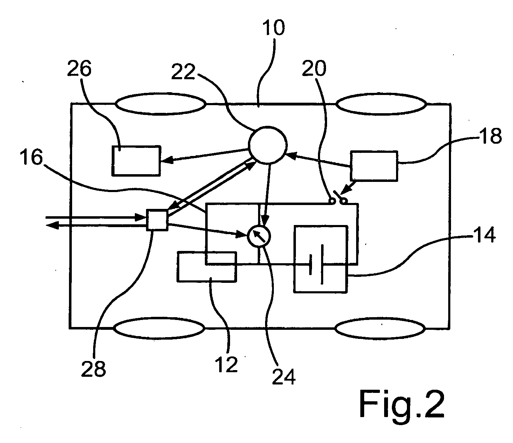

Ein Elektrofahrzeug 10 weist eine elektrische Kraftmaschine 12 auf, welche von einer Batterie 14 in einem Stromkreis 16 mit elektrischer Energie versorgt wird (vgl. Fig. 2). Sollen nun Wartungsarbeiten beispielsweise an der elektrischen Kraftmaschine 12 vorgenommen werden, so muss aus Sicherheitsgründen zunächst der Stromkreis 16 unterbrochen werden. Hierzu fordert ein Service-Techniker mittels einer Bedieneinheit 18 an, dass ein Schaltmittel 20 des Stromkreises derart betätigt wird, dass in dem Stromkreis 16 keine oder nur noch eine sehr geringe Spannung messbar ist. Beispielsweise kann der Service Techniker hierzu den "Service Plug" des Elektrofahrzeugs ziehen (Schritt S10, Fig. 1).

Dieses Betätigen des "Service Plugs" wird nun auch von einer Steuereinheit 22 des Elektrofahrzeugs 10 erkannt. Diese kann beispielsweise ein "Battery Management System" oder auch ein Motorsteuergerät des Elektrofahrzeugs 10 sein. Es ist auch denkbar, dass diese beiden Steuereinheiten und eventuell auch weitere Steuereinheiten des Elektrofahrzeugs 10 gleichzeitig das Betätigen des Service Plugs erkennen und die Funktionen der Steuereinheit 22 gemeinsam übernehmen.

Die Steuereinheit 22 steuert dann eine Messeinheit 24 an, mittels welcher die an dem Stromkreis 16 anliegende Spannung gemessen wird (Schritt S12, Fig. 1). Eine derartige Messung kann gleichzeitig an verschiedenen Stellen durchgeführt werden, um beispielsweise Fehlfunktionen einer Messeinheit feststellen zu können. Gleichzeitig zur Spannungsmessung kann auch ein Status des Hauptschutzrelais des Stromkreises 16 oder auch eine Isolation des Stromkreises 16 in geeigneter Weise überprüft werden.

Die Steuereinheit 22 vergleicht dann den gemessenen Wert für die in dem Stromkreis 16 herrschende Spannung mit vorgegebenen Werten für die Spannung (Schritt S14, Figur 1). Letztere können beispielsweise in einem Speicher der Steuereinheit 22 abgelegt sein. Herrscht in dem Stromkreis 16 eine Spannung von weniger als beispielsweise 20 Volt, und ist der Status des Hauptschutzrelais des Stromkreises 16 sowie die Isolation des Stromkreises ebenfalls in einem vorgegebenen Zustand, so veranlasst die Steuereinheit 22, dass beispielsweise durch Aufleuchten eines Lichts einer Anzeigeeinheit 26 des Elektrofahrzeugs 10 anzeigt wird, dass der angeforderte Zustand für den Stromkreis 16 eingestellt ist (Schritt S16, Fig. 1).

Die Steuereinheit 22 kann außerdem veranlassen, dass durch die Anzeigeeinheit 26 angezeigt wird, ob der "Service Plug" betätigt wurde. Dem Service Techniker liegen dann bereits zwei Informationen vor, anhand derer er abschätzen kann, ob Wartungsarbeiten nun gefahrlos durchgeführt werden können.

Parallel zu den Schritten S12 bis S16 wird ein weiteres, unabhängiges Überprüfen des Zustands des Stromkreises 16 durchgeführt. Hierzu veranlasst eine außerhalb des Elektrofahrzeugs 10 angeordnete Steuereinheit, welche beispielsweise in bekannter Weise zum Durchführen einer "Geführten Fehlersuche (GFS)" ausgelegt ist, dass die Messeinheit 24 des Elektrofahrzeugs 10 weitere, unabhängige Spannungsmessungen durchführt. Auch der Status des Hauptschutzrelais sowie die Isolation des Stromkreises 16 kann unabhängig nochmals überprüft werden. Damit dies möglich ist, weist das Elektrofahrzeug 10 Kommunikationsmittel 28 mit einer Schnittstelle auf, durch welche Daten zwischen der Steuereinheit außerhalb des Elektrofahrzeugs 10 und der Steuereinheit 22 beziehungsweise der Messeinheit 24 ausgetauscht werden. So sind gemessene Werte für die in dem Stromkreis 16 herrschende Spannung einfach durch die Steuereinheit außerhalb des Elektrofahrzeugs 10 auslesbar.

Diese vergleicht dann die weiteren, unabhängig gemessenen Werte für die in dem Stromkreis 16 herrschende Spannung mit den für den angeforderten Zustand vorgegebenen Werten für die Spannung. Herrscht eine Spannung von weniger als beispielsweise 20 Volt in dem Stromkreis 16, so zeigt auch die Steuereinheit außerhalb des Elektrofahrzeugs 10 an, dass der angeforderte Zustand für den Stromkreis 16 eingestellt ist. Der Service-Techniker bekommt hierdurch eine dritte Information, die ihm ermöglicht, die Unfallgefahr bei Wartungsarbeiten an dem Hochspannungssystem des Elektrofahrzeugs 10 noch besser abschätzen zu können. So kann einfach, sicher und kostensparend überprüft werden, ob Wartungsarbeiten an dem Elektrofahrzeug 10 gefahrlos durchgeführt werden können.

## Patentansprüche

1. Verfahren zum Überprüfen eines Zustands eines Stromkreises (16) eines Kraftfahrzeugs (10), durch folgende Schritte:
- Anfordern eines Zustands für den Stromkreis (16), (S10)
- Messen eines aktuellen Werts für wenigstens eine auf den Stromkreis (16) bezogene Größe, aus welcher der Zustand des Stromkreises (16) ableitbar ist, durch zumindest eine Messeinheit (24) des Kraftfahrzeugs (10), (S12)
- Prüfen durch zumindest eine Steuereinheit (22) des Kraftfahrzeugs (10), ob der aktuelle Wert für die Größe zumindest einem für den angeforderten Zustand vorgegebenen Wert für die Größe entspricht, (S14)
- wenn der aktuelle Wert für die Größe dem zumindest einen für den angeforderten Zustand vorgegebenen Wert für die Größe entspricht, Anzeigen dass der angeforderte Zustand des Stromkreises (16) eingestellt ist (S16),
**dadurch gekennzeichnet, dass**
parallel zur Gesamtheit der Schritte des
- Messens des aktuellen Werts für die wenigstens eine auf den Stromkreis bezogene Größe, aus welcher der Zustand des Stromkreises (16) ableitbar ist, durch die zumindest eine Messeinheit (24) des Kraftfahrzeugs (10), (S12)
- Prüfens durch die zumindest eine Steuereinheit (22) des Kraftfahrzeugs (10), ob der aktuelle Wert für die Größe zumindest einem für den angeforderten Zustand vorgegebenen Wert für die Größe entspricht, (S14) und des
- Anzeigens, dass der angeforderte Zustand des Stromkreises (16) eingestellt ist, wenn der aktuelle Wert für die Größe dem zumindest einen für den angeforderten Zustand vorgegebenen Wert für die Größe entspricht,
die Gesamtheit der Schritte
- zumindest eines weiteren Messens eines weiteren aktuellen Werts für die wenigstens eine auf den Stromkreis (16) bezogene Größe durch die wenigstens eine Messeinheit (24) des Kraftfahrzeugs (10), aus welcher der Zustand des Stromkreises (16) ableitbar ist,
- eines weiteres Prüfens, ob der aktuelle Wert für die Größe zumindest einem vorgegebenen Wert für die Größe entspricht, sowie
- eines weiteren Anzeigens, dass der angeforderte Zustand des Stromkreises (16) eingestellt ist, wenn der aktuelle Wert für die Größe dem zumindest einen für den angeforderten Zustand vorgegebenen Wert für die Größe entspricht,
von wenigstens einer weiteren Steuereinheit außerhalb des Kraftfahrzeugs (10) veranlasst beziehungsweise durchgeführt wird.

2. Verfahren nach Anspruch 1,
**dadurch gekennzeichnet, dass**
die Größe eine in dem Stromkreis (16) herrschende Spannung ist.

3. Verfahren nach Anspruch 1 oder 2,
**dadurch gekennzeichnet, dass**
angezeigt wird, ob das Anfordern des Zustands erfolgte.

## Claims

1. Method to check the condition of a circuit (16) of a motor vehicle (10) using the following steps:
- requesting a condition for the circuit (16), (S10)
- measuring of the actual value for at least one factor related to the circuit (16) from which the condition of the circuit (16) can be derived by means of at least one measuring unit (24) of the motor vehicle (10), (S12)
- check using at least one control unit (22) of the motor vehicle (10) if the actual value for the factor corresponds to at least one value specified for the requested condition for the factor (S14)
- if the actual value for the factor corresponds to at least one value specified for the requested condition for the factor, displaying that the requested condition of the circuit (16) has been configured (S16),
**characterised by** the fact that
parallel to all the steps of
- measuring of the actual value for the at least one factor related to the circuit from which the condition of the circuit can be derived (16) by means of at least one measuring unit (24) of the motor vehicle (10), (S12)
- check using the at least one control unit (22) of the motor vehicle (10) if the current value for the factor corresponds to at least one value specified for the requested condition for the factor (S14) and
- displaying that the requested condition of the circuit (16) has been configured if the current value for the factor corresponds to at least one value specified for the requested condition for the factor, all the steps of
- at least one further measuring of another actual value for the at least one factor related to the circuit (16) by the at least one measuring unit (24) of the motor vehicle (10), from which the condition of the circuit (16) can be derived,
- another checking if the current value for the factor corresponds to at least one specified value for the factor as well as
- another displaying that the requested condition of the circuit (16) has been configured, if the actual value for the factor corresponds to the at least one value specified for the requested condition for the factor, are carried out or prompted by at least one other control unit outside of the motor vehicle (10).

2. Method according to claim 1,
**characterised by** the fact that
the factor is a predominate voltage in the circuit (16).

3. Method according to claim 1 or 2
**characterised by** the fact that
it is indicated if the requesting the condition is carried out.

## Revendications

1. Procédé pour contrôler un état d'un circuit de courant (16) d'un véhicule automobile (10), avec les étapes suivantes :
- demander un état pour le circuit de courant (16), (S10)
- mesurer une valeur actuelle pour au moins une grandeur qui se rapporte au circuit de courant (16) et à partir de laquelle l'état du circuit de courant (16) peut être déduit, ceci au moyen d'au moins une unité de mesure (24) du véhicule automobile (10), (S12)
- vérifier au moyen d'au moins une unité de commande (22) du véhicule automobile (10) si la valeur actuelle pour la grandeur correspond au moins à une valeur, prédéterminée pour l'état demandé, pour la grandeur, (S14)
- si la valeur actuelle pour la grandeur correspond à l'au moins une valeur, prédéterminée pour l'état demandé, pour la grandeur, afficher que l'état demandé du circuit de courant (16) est réglé, (S16)
**caractérisé en ce que**
parallèlement à l'ensemble des étapes suivantes :
- mesurer la valeur actuelle pour l'au moins une grandeur qui se rapporte au circuit de courant et à partir de laquelle l'état du circuit de courant (16) peut être déduit, ceci au moyen de l'au moins une unité de mesure (24) du véhicule automobile (10), (S12)
- vérifier au moyen de l'au moins une unité de commande (22) du véhicule automobile (10) si la valeur actuelle pour la grandeur correspond au moins à une valeur, prédéterminée pour l'état demandé, pour la grandeur, (S14) et
- afficher que l'état demandé du circuit de courant (16) est réglé si la valeur actuelle pour la grandeur correspond à l'au moins une valeur, prédéterminée pour l'état demandé, pour la grandeur, l'ensemble des étapes suivantes :
- effectuer au moins une autre mesure d'une autre valeur actuelle pour l'au moins une grandeur qui se rapporte au circuit de courant (16), ceci au moyen de l'au moins une unité de mesure (24) du véhicule automobile (10), grandeur à partir de laquelle l'état du circuit de courant (16) peut être déduit,
- effectuer une autre vérification pour savoir si la valeur actuelle pour la grandeur correspond au moins à une valeur prédéterminée pour la grandeur, et
- effectuer un autre affichage indiquant que l'état demandé du circuit de courant (16) est réglé si la valeur actuelle pour la grandeur correspond à l'au moins une valeur, prédéterminée pour l'état demandé, pour la grandeur,
est déclenché ou effectué par au moins une autre unité de commande à l'extérieur du véhicule automobile (10).

2. Procédé selon la revendication 1, **caractérisé en ce que** la grandeur est une tension régnant dans le circuit de courant (16).

3. Procédé selon la revendication 1 ou 2, **caractérisé en ce que** l'on affiche si la demande de l'état s'est effectuée.
